# DEMANDE DE BREVET EUROPEEN

(11) **EP 1 783 814 A1**
(43) Date de publication de la demande: **09.05.2007**
(21) Numéro de dépôt: 05292354.7
(22) Date de dépôt: 07.11.2005
(51) Int. Cl.: H01J 37/34, C23C 14/02

(54) **Procédé et installation d'avivage sous vide par pulvérisation magnétron d'une bande métallique**

(71) Demandeur: ARCELOR France, 93212 La Plaine Saint Denis Cedex (FR)
(72) Inventeur: Cornil, Hugues, 4570 Marchin (BE); Deweer, Benoit, 1970 Wezembeek-Oppem (BE); Maboge, Claude, 5650 Castillon (BE); Mottoulle, Jacques, 5020 Namur (Malonne) (BE)
(74) Mandataire: Plaisant, Sophie Marie

(57) **Abrégé**

L'invention concerne un procédé d'avivage sous vide par pulvérisation magnétron dans une enceinte sous vide (2) d'une bande métallique (4) défilant sur un rouleau d'appui (3) en regard d'une contre-électrode (5), dans lequel on crée un plasma dans un gaz à proximité de ladite bande métallique (4), de manière à générer des radicaux et/ou des ions agissant sur cette bande (4), et dans lequel on sélectionne au moins un circuit magnétique fermé (7) dont la largeur est sensiblement égale à celle de ladite bande métallique (4), parmi une série d'au moins deux circuits magnétiques fermés (7) de largeurs différentes et fixes, puis que l'on achemine ledit circuit magnétique (7) sélectionné pour le positionner en regard de ladite bande métallique (4), puis que l'on procède à l'avivage de ladite bande métallique (4) en mouvement. Elle concerne également une installation d'avivage (1) pour la mise en oeuvre du procédé.

## Description

La présente invention concerne un procédé et une installation d'avivage sous vide par pulvérisation magnétron d'une bande métallique, telle qu'une bande d'acier, par exemple.

Lors des opérations de revêtement sous vide d'une bande d'acier, l'état de propreté de la bande avant dépôt est l'un des facteurs clés de réussite, car il détermine la bonne adhérence du revêtement à déposer. Un des procédés utilisés pour ce faire est l'avivage sous vide par pulvérisation magnétron encore appelé etching. Ce procédé consiste à créer un plasma entre la bande et une contre-électrode, dans un gaz permettant de générer des radicaux et/ou ions. Ces ions vont, dans les conditions normales de fonctionnement, être accélérés vers la surface de la bande à décaper, et venir arracher des atomes superficiels, nettoyant ainsi la surface éventuellement souillée, tout en l'activant.

La bande à décaper se déplace dans une chambre sous vide en regard d'une contre-électrode. Cette dernière est polarisée positivement par rapport au substrat, lui-même préférentiellement relié à la masse. Un ensemble d'aimants positionné à l'arrière de la bande confine le plasma créé auprès de celle-ci. Afin de positionner de façon très précise la bande métallique à traiter, par rapport à la contre-électrode nécessaire à la mise en oeuvre de la pulvérisation magnétron, la bande métallique est généralement disposée sur un rouleau d'appui qui peut être mis en rotation autour de son axe.

La mise en oeuvre à l'échelle industrielle de ce type de traitement de surface impose des contraintes supplémentaires au procédé. Il est en particulier nécessaire de pouvoir adapter la largeur de la surface avivée à la largeur de la bande d'acier, qui peut varier au cours du temps. Une telle adaptation impose de limiter l'action des radicaux ou ions générés dans le plasma à la zone délimitée par la bande métallique à décaper.

A cet effet, on connaît le brevet EP-A-0 603 587 décrivant une installation permettant d'éroder un substrat de manière homogène à l'aide d'un plasma. Cette installation permet de déplacer la zone d'avivage sur de faibles longueurs sans pour autant changer sa dimension dans une quelconque direction. Celle-ci rend l'érosion du substrat plus uniforme, mais ne permet pas de s'adapter réellement à une variation de largeur de la bande à traiter.

On connaît également EP-A-0 878 565 qui décrit plusieurs installations visant à résoudre ce problème de la variation de largeur d'un substrat à traiter par etching. Un premier dispositif représenté en figure 4 et 5, met en oeuvre un circuit magnétique composé de trois circuits unitaires de même largeur. Le circuit central est fixe et les deux autres peuvent se déplacer latéralement par rapport à la bande pour adapter la largeur du circuit magnétique total à la largeur de la bande. Lorsque la bande n'est pas positionnée sur un rouleau ou repose sur un rouleau non conducteur, il est difficile d'allumer un race track s'étendant partiellement sur la bande et partiellement sur une surface isolante. En effet, les rives tendent à créer un champ électrique non uniforme (effet de pointe), et un race track entrecoupé à ce niveau entraîne l'apparition de nombreux arcs lorsque l'on souhaite monter en puissance. Le dispositif fonctionne donc uniquement lorsque les circuits magnétiques latéraux ne se trouvent pas en regard de la bande d'acier ou se trouvent totalement en regard de celle-ci. Dans ce dernier cas cependant, l'avivage n'est pas uniforme car les surfaces d'action des circuits magnétiques se chevauchent afin de s'adapter à la largeur de la bande.

Lorsque la bande est positionnée sur un rouleau conducteur, le dispositif ne peut fonctionner sans l'éroder de façon continue et importante, entraînant des remplacements fréquents.

Ce document décrit un second dispositif, représenté aux figures 1 à 3, mettant en oeuvre un circuit magnétique constitué d'aimants permanents en forme de cadre rectangulaire 3 (pôle nord) et d'aimants permanents formés de trois barreaux parallèles successifs 4 (pôle sud), ou inversement. Le barreau central 4a du pôle sud comme les cotés longitudinaux 3a du cadre 3 formant le pôle nord sont fixes. Les cotés d'extrémité 3b du cadre 3 et les barreaux 4b du pôle sud peuvent coulisser ensemble dans le sens transversal par rapport au sens de déplacement de la bande. Lorsque la bande n'est pas positionnée sur un rouleau ou repose sur un rouleau non conducteur, un problème se pose de nouveau au niveau des rives. Des arcs apparaissent lorsque le circuit magnétique dépasse légèrement du bord de bande afin d'aviver correctement cette partie. De plus, l'avivage est inhomogène lorsque les surfaces d'action des aimants 4 se chevauchent afin de s'adapter à largeur de la bande.

Par contre, lorsque la bande est positionnée sur un rouleau conducteur, l'avivage est toujours non uniforme lorsque les surfaces d'action des aimants 4 se chevauchent. En outre, lorsque la bande est étroite, les aimants nord 3a non en regard de la surface à traiter perturbent également le champ magnétique.

Ce document divulgue également un troisième dispositif, représenté en figure 6, mettant en oeuvre un circuit magnétique de structure multicellulaire. Cette structure est constituée d'une succession de circuits magnétiques indépendants 2', 2",.., s'étendant en rangées successives 12, 12'. Si la bande n'est pas positionnée sur un rouleau cylindrique ou repose sur un rouleau non conducteur, l'installation fonctionne mais entraîne la formation d'arcs au niveau des circuits magnétiques coupant le bord de bande. Si la bande est positionnée sur un rouleau conducteur, l'installation ne permet plus d'adapter la largeur avivée à différentes largeurs de substrat.

La présente invention a donc pour but de remédier aux inconvénients de procédés de l'art antérieur en mettant à disposition un procédé et une installation d'avivage sous vide par sputtering magnétron de la surface d'une bande métallique en défilement sur un rouleau d'appui, qui permette d'adapter le traitement à une variation de la largeur de la bande, tout en traitant la totalité de la surface de façon uniforme et sans détériorer le rouleau d'appui.

A cet effet, l'invention a pour premier objet un procédé d'avivage sous vide par pulvérisation magnétron dans une enceinte sous vide d'une bande métallique défilant sur un rouleau d'appui en regard d'une contre-électrode, dans lequel on crée un plasma dans un gaz à proximité de ladite bande métallique, de manière à générer des radicaux et/ou des ions agissant sur cette bande, caractérisé en ce que l'on sélectionne au moins un circuit magnétique fermé dont la largeur est sensiblement égale à celle de ladite bande métallique, parmi une série d'au moins deux circuits magnétiques fermés de largeurs différentes et fixes, puis que l'on achemine ledit circuit magnétique sélectionné pour le positionner en regard de ladite bande métallique, puis que l'on procède à l'avivage de ladite bande métallique en mouvement.

Le procédé selon l'invention peut en outre incorporer les caractéristiques suivantes, prises isolément ou en combinaison :
- le rouleau d'appui est un rouleau conducteur.
- le ou les circuits magnétiques fermés comprennent des rangées d'aimants disposés bord à bord, deux rangées successives présentant des polarités opposées,
- le ou les circuits magnétiques sélectionnés génèrent un champ magnétique tangent à la bande métallique d'une intensité supérieure à 300 Gauss,
- le ou les circuits magnétiques sont disposés sur la surface extérieure d'un support cylindrique placé à l'intérieur du rouleau d'appui de manière concentrique par rapport au rouleau, le support cylindrique étant mobile en rotation autour de son axe,
- le ou les circuits magnétiques sont placés sur une culasse en acier doux,
- le ou les circuits magnétiques sont ordonnés par taille croissante à la surface du support cylindrique,
- les circuits magnétiques non sélectionnés sont occultés par un dispositif de neutralisation ne laissant pas passer un champ magnétique de plus de 100 Gauss desdits circuits magnétiques vers la bande métallique,
- le dispositif de neutralisation est en deux parties positionnées de part et d'autre dudit ou desdits circuits magnétiques, définissant une fenêtre d'avivage,
- on traite une première bobine de bande métallique présentant une largeur constante L1 puis une seconde bobine de largeur constante L2, la première bobine étant traitée au moyen d'un circuit magnétique fermé de largeur L1 que l'on amène au-dessus de ladite bande, puis l'on retire ledit circuit pour le remplacer par un second circuit de largeur L2 avec lequel on traite ladite seconde bobine de bande métallique présentant une largeur constante L2,
- la bande métallique avivée est ensuite revêtue sous vide par un revêtement de protection,
- la bande métallique est une bande en acier.

Un second objet de l'invention est constitué par une installation d'avivage sous vide par pulvérisation magnétron d'une bande métallique comprenant un rouleau d'appui en regard d'une contre-électrode, des moyens de polarisation de ladite bande métallique, des moyens permettant de créer un plasma dans un gaz entre ladite bande et ladite contre-électrode, une série d'au moins deux circuits magnétiques fermés de largeurs différentes et fixes, susceptibles chacun de traiter seul l'intégralité de la largeur d'une bande métallique, et des moyens d'acheminement d'un ou plusieurs desdits circuits magnétiques en regard de ladite bande métallique.

L'installation selon l'invention peut en outre incorporer les caractéristiques suivantes, prises isolément ou en combinaison :
- le rouleau d'appui est un rouleau conducteur,
- le ou les circuits magnétiques fermés comprennent des rangées d'aimants disposés bord à bord, deux rangées successives présentant des polarités opposées,
- le ou les circuits magnétiques peuvent générer un champ magnétique tangent à la bande métallique d'une intensité supérieure à 300 Gauss,
- le ou les circuits magnétiques sont disposés sur la surface extérieure d'un support cylindrique placé à l'intérieur du rouleau d'appui de manière concentrique par rapport au rouleau, le support cylindrique étant mobile en rotation autour de son axe,
- le ou les circuits magnétiques sont placés sur une culasse en acier doux,
- le ou les circuits magnétiques sont ordonnés par taille croissante à la surface du support cylindrique,
- l'installation comprend en outre un dispositif de neutralisation ne laissant pas passer un champ magnétique de plus de 100 Gauss des circuits magnétiques vers la bande métallique,
- l'installation de neutralisation est en deux parties pouvant être positionnées de part et d'autre dudit ou desdits circuits magnétiques, entre la bande métallique et la contre-électrode.

L'invention va à présent être décrite plus en détail en référence aux figures annexées qui représentent :
- figure 1 : vue schématique en coupe d'un mode de réalisation d'une installation selon l'invention,
- figure 2 : vue schématique de dessus d'une partie de l'installation de la figure 1.

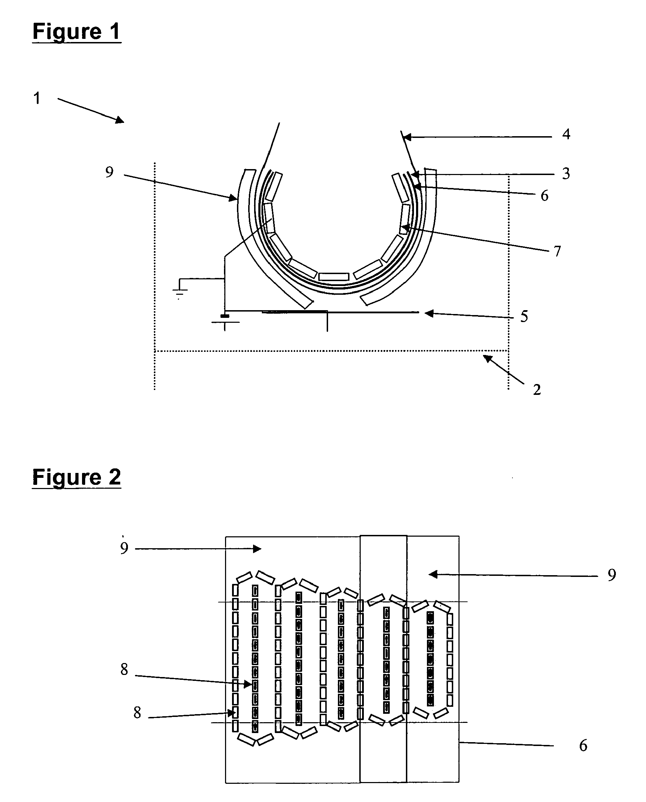

Si l'on considère tout d'abord la figure 1, on peut y voir une installation 1 selon l'invention comprenant une chambre 2 sous vide dans laquelle est monté un rouleau d'appui 3 présentant une surface cylindrique et pouvant tourner autour d'un axe. Une bande d'acier à décaper 4 s'enroule autour de ce rouleau 3 en regard d'une contre-électrode 5. Celle-ci est polarisée positivement par rapport à la bande d'acier, qui est-elle préférentiellement reliée à la masse.

Le système de contre-électrode peut-être constitué d'une ou plusieurs électrodes et peut prendre différentes formes, telle qu'un fil par exemple.

A l'intérieur du rouleau 3 est monté un support en forme de tambour 6 qui accueille en son sein un certain nombre de circuits magnétiques 7. Le rouleau d'appui 3 doit être de diamètre suffisant pour accueillir en son sein le nombre adéquat de pistes magnétiques 7 permettant de s'adapter à l'ensemble des largeurs prévues dans la gamme de fabrication.

Le rouleau 3 étant continuellement érodé par le plasma qui dépasse des rives de la bande 4, la table de celui-ci doit donc être considérée comme une pièce d'usure. Le rouleau 3 doit être facilement rectifiable et la table facilement remplaçable en fin de vie. Cette durée de vie dépend de la vitesse de pulvérisation de la surface. Le choix d'un éventuel revêtement conducteur ayant une vitesse d'érosion plus faible peut être fait pour améliorer sa durée de vie.

Le rouleau 3 peut éventuellement être relié à la terre et est de préférence conducteur. En effet, ce mode de réalisation permet de limiter, voire d'éviter l'apparition d'arcs sur les rives de la bande lors de l'avivage, ce qui pourrait rendre le traitement non uniforme entre le centre de la bande et ses rives.

Le tambour 6 peut être mis en rotation en cours de production à l'intérieur du rouleau d'appui 3. Ce tambour 6 doit être de diamètre suffisant pour accueillir le nombre adéquat de pistes magnétiques 7 permettant de s'adapter à l'ensemble des largeurs prévues dans la gamme de fabrication.

Comme on peut le voir en figure 2, les circuits magnétiques 7 sont de largeur différente et croissante dans la direction transversale à la direction de déplacement de la bande d'acier 4.

Chaque circuit magnétique 7 est constitué d'aimants 8 pouvant être montés sur des pièces en acier doux. Celles-ci peuvent être soit des éléments indépendants rapportés sur le tambour, soit une virole servant de berceau.

Avantageusement, une culasse en acier doux sous les aimants 8 permet de renforcer le champ induit au-dessus du montage magnétron, et évite aux lignes de champ de se perdre loin à l'arrière des aimants 8.

Les aimants 8 sont disposés de manière à former au moins une piste magnétique fermée où le champ tangeant à la bande est supérieur à 300 Gauss, et de préférence supérieur à 500 Gauss.

Les aimants 8 d'une même rangée sont de préférence disposés bord à bord afin d'éviter des distorsions en créneau du champ qui réduisent l'efficacité du confinement.

Par ailleurs, comme on peut le voir en figure 1, des caches de neutralisation 9 entourent la totalité du rouleau d'appui 3, excepté la partie active dans la fenêtre d'avivage. Les caches 9 peuvent être réalisés en matériau non ferromagnétique, et peuvent être en volume plein ou encore creux mais fermés. L'épaisseur de ces caches 9 est telle que le champ magnétique sortant de ceux-ci est inférieur à 100 Gauss et avantageusement inférieur à 50 Gauss, de manière à éviter l'allumage d'un plasma en dehors de la zone d'avivage.

Le fonctionnement du dispositif selon l'invention va à présent être décrit. Lorsque l'on souhaite décaper la bande métallique 4, qui peut être en acier, en aluminium, en cuivre, etc, on la polarise, par exemple négativement, et on la fait défiler dans l'enceinte sous vide 2. Un plasma est allumé dans cette enceinte 2 entre la contre-électrode, polarisée positivement, et la bande 4. Le bombardement d'ions et/ou de radicaux sur la bande 4 permet de l'aviver.

Par rotation du tambour 6, le ou les circuits magnétiques 7 de largeur désirée sont sélectionnés et positionnés en regard de la contre-électrode 5. Les caches de neutralisation du champ magnétique 9, sont positionnés de part et d'autre du ou des circuits magnétiques 7, afin de régler la fenêtre d'avivage aux dimensions exactes de la bande 4 en défilement. Lorsque la bande 4 change de largeur, il suffit de faire tourner le tambour 6 jusqu'à positionner le circuit magnétique 7 de largeur adaptée en face de la contre-électrode.

On voit donc que le dispositif et le procédé selon l'invention permettent de traiter une bande métallique de largeur variable de façon efficace et simple, en la traitant de façon uniforme sur l'ensemble de sa surface y compris les rives, sans générer d'arcs électriques et sans détériorer le rouleau d'appui qui ne subit pas d'avivage.

Par ailleurs, on peut également utiliser le dispositif selon l'invention pour traiter des bobines successives de bandes métalliques de largeur constante mais différente, les unes à la suite des autres. Ainsi, si on doit traiter une première bobine de bande de largeur constante L1, puis une seconde bobine de bande de largeur constante L2, on positionne tout d'abord un premier circuit magnétique 7 de largeur L1 au-dessus de la bande 4 et on traite l'intégralité de la première bobine sans modifier l'installation. On fait ensuite tourner le tambour 6 de telle sorte qu'un second circuit magnétique 7 de largeur L2 soit en face du trajet de la bande 4 et on traite la seconde bobine de largeur L2, après avoir positionné les caches 9 pour neutraliser les autres circuits 7 non sélectionnés. En fonction de la gamme de fabrication de la ligne industrielle, on peut ainsi prévoir avantageusement un tambour 6 muni d'autant de circuits magnétiques 7 qu'il y a de largeurs de bandes dans cette gamme de fabrication.

## Revendications

1. Procédé d'avivage sous vide par pulvérisation magnétron dans une enceinte sous vide (2) d'une bande métallique (4) défilant sur un rouleau d'appui (3) en regard d'une contre-électrode (5), dans lequel on crée un plasma dans un gaz à proximité de ladite bande métallique (4), de manière à générer des radicaux et/ou des ions agissant sur cette bande (4), **caractérisé en ce que** l'on sélectionne au moins un circuit magnétique fermé (7) dont la largeur est sensiblement égale à celle de ladite bande métallique (4), parmi une série d'au moins deux circuits magnétiques fermés (7) de largeurs différentes et fixes, puis que l'on achemine ledit circuit magnétique (7) sélectionné pour le positionner en regard de ladite bande métallique (4), puis que l'on procède à l'avivage de ladite bande métallique (4) en mouvement.

2. Procédé selon la revendication 1, dans lequel ledit rouleau d'appui (3) est un rouleau conducteur.

3. Procédé selon l'une quelconque des revendications 1 ou 2, dans lequel ledit ou lesdits circuits magnétiques fermés (7) comprennent des rangées d'aimants (8) disposés bord à bord, deux rangées successives présentant des polarités opposées.

4. Procédé selon l'une quelconque des revendications 1 à 3, dans lequel ledit ou lesdits circuits magnétiques (7) sélectionnés génèrent un champ magnétique tangent à ladite bande métallique (4) d'une intensité supérieure à 300 Gauss.

5. Procédé selon l'une quelconque des revendications 1 à 4, dans lequel ledit ou lesdits circuits magnétiques (7) sont disposés sur la surface extérieure d'un support cylindrique (6) placé à l'intérieur dudit rouleau d'appui (3) de manière concentrique par rapport audit rouleau (3), le support cylindrique (6) étant mobile en rotation autour de son axe.

6. Procédé selon l'une quelconque des revendications 1 à 5, dans lequel ledit ou lesdits circuits magnétiques (7) sont placés sur une culasse en acier doux.

7. Procédé selon l'une quelconque des revendications 5 ou 6, dans lequel ledit ou lesdits circuits magnétiques (7) sont ordonnés par taille croissante à la surface dudit support cylindrique (6).

8. Procédé selon l'une quelconque des revendications 1 à 7, dans lequel les circuits magnétiques (7) non sélectionnés sont occultés par un dispositif de neutralisation (9) ne laissant pas passer un champ magnétique de plus de 100 Gauss desdits circuits magnétiques (7) vers la bande métallique (4).

9. Procédé selon la revendication 8, dans lequel ledit dispositif de neutralisation (9) est en deux parties positionnées de part et d'autre dudit ou desdits circuits magnétiques (7), définissant une fenêtre d'avivage.

10. Procédé selon l'une quelconque des revendications 1 à 9, dans lequel on traite une première bobine de bande métallique (4) présentant une largeur constante L1 puis une seconde bobine de largeur constante L2, la première bobine étant traitée au moyen d'un circuit magnétique fermé (7) de largeur L1 que l'on amène au-dessus de ladite bande (4), puis l'on retire ledit circuit (7) pour le remplacer par un second circuit (7) de largeur L2 avec lequel on traite ladite seconde bobine de bande métallique (4) présentant une largeur constante L2.

11. Procédé selon l'une quelconque des revendications 1 à 10, dans lequel la bande métallique (4) est une bande en acier.

12. Procédé selon l'une quelconque des revendications 1 à 11, dans lequel ladite bande métallique (4) avivée est ensuite revêtue sous vide par un revêtement de protection.

13. Installation d'avivage sous vide par pulvérisation magnétron (1) d'une bande métallique (4) comprenant un rouleau d'appui (3) en regard d'une contre-électrode (5), des moyens de polarisation de ladite bande métallique (4), des moyens permettant de créer un plasma dans un gaz entre ladite bande (4) et ladite contre-électrode (5), une série d'au moins deux circuits magnétiques fermés (7) de largeurs différentes et fixes, susceptibles chacun de traiter seul l'intégralité de la largeur d'une bande métallique (4), et des moyens d'acheminement d'un ou plusieurs desdits circuits magnétiques (7) en regard de ladite bande métallique (4).

14. Installation selon la revendication 13, dans laquelle ledit rouleau d'appui (3) est un rouleau conducteur.

15. Installation selon l'une quelconque des revendications 13 ou 14, dans laquelle ledit ou lesdits circuits magnétiques fermés (7) comprennent des rangées d'aimants (8) disposés bord à bord, deux rangées successives présentant des polarités opposées.

16. Installation selon l'une quelconque des revendications 13 à 15, dans laquelle ledit ou lesdits circuits magnétiques (7) peuvent générer un champ magnétique tangent à ladite bande métallique (4) d'une intensité supérieure à 300 Gauss.

17. Installation selon l'une quelconque des revendications 13 à 16, dans laquelle ledit ou lesdits circuits magnétiques (7) sont disposés sur la surface extérieure d'un support cylindrique (6) placé à l'intérieur dudit rouleau d'appui (3) de manière concentrique par rapport audit rouleau (3), le support cylindrique (6) étant mobile en rotation autour de son axe.

18. Installation selon l'une quelconque des revendications 13 à 17, dans laquelle ledit ou lesdits circuits magnétiques (7) sont placés sur une culasse en acier doux.

19. Installation selon l'une quelconque des revendications 17 ou 18, dans laquelle ledit ou lesdits circuits magnétiques (7) sont ordonnés par taille croissante à la surface dudit support cylindrique (6).

20. Installation selon l'une quelconque des revendications 13 à 19, comprenant en outre un dispositif de neutralisation (9) ne laissant pas passer un champ magnétique de plus de 100 Gauss desdits circuits magnétiques (7) vers la bande métallique (4).

21. Installation selon la revendication 20, dans lequel ledit dispositif de neutralisation (9) est en deux parties pouvant être positionnées de part et d'autre dudit ou desdits circuits magnétiques (7), entre ladite bande métallique (4) et la contre-électrode (5).
